# EUROPÄISCHE PATENTSCHRIFT

(11) **EP 3 419 391 B1**
(45) Veröffentlichungstag und Bekanntmachung des Hinweises auf die Patenterteilung: **02.08.2023**
(21) Anmeldenummer: 18178277.2
(22) Anmeldetag: 18.06.2018
(51) Int. Cl.: H05K 1/18, F21K 9/64, H05K 1/03, H05K 1/02, G08B 13/24, H01L 33/50

(54) **FOLIENAUFBAU MIT ERZEUGEN VON SICHTBAREM LICHT MITTELS LED-TECHNOLOGIE**
FILM STRUCTURE WITH GENERATION OF VISIBLE LIGHT BY MEANS OF LED TECHNOLOGY
STRUCTURE STRATIFIÉE PERMETTANT DE PRODUIRE DE LA LUMIÈRE VISIBLE AU MOYEN DE LA TECHNOLOGIE LED

(30) Priorität: 19.06.2017 DE 102017113380
(43) Veröffentlichungstag der Anmeldung: 26.12.2018
(73) Patentinhaber: Schreiner Group GmbH & Co. KG, 85764 Oberschleissheim (DE)
(72) Erfinder: Becker, Johannes, 85304 Ilmmünster (DE); Gepp, Sebastian, 01309 Dresden (DE); Hartmann, Manfred, verstorben (DE); Wiederrecht, Hartmut, 85386 Eching (DE)
(74) Vertreter: Epping - Hermann - Fischer

(56) Entgegenhaltungen:
- WO-A1-2016/039908
- DE-A1-102012 101 463
- DE-A1-102014 110 067
- DE-B3-102012 102 804
- DE-B4-102009 020 540
- US-A1- 2002 088 987
- US-A1- 2005 085 010
- US-A1- 2013 033 888

## Beschreibung

Die Erfindung betrifft einen Folienaufbau mit Erzeugen von sichtbarem Licht mit Hilfe einer LED-Technologie. Die Erfindung betrifft darüber hinaus ein Verfahren zum Herstellen eines Folienaufbaus mit Erzeugen von sichtbarem Licht.

Zur Beleuchtung werden heute in vielen Anwendungsbereichen LEDs eingesetzt. Dazu werden die LEDs in der Regel auf eine Leiterplatte gelötet. Insbesondere zur Beleuchtung kleiner Flächen oder auch zur Hintergrundbeleuchtung einer Fläche oder von Symbolen benötigt eine derartige Anordnung aus LEDs montiert auf einer Leiterplatte einen großen Bauraum. Die Aufbauten benötigen oftmals viele elektronische Teile, so dass die Konstruktion vielfach kompliziert ist und die Lichtausbeute aufwändig ermittelt werden muss.

LEDs strahlen üblicherweise Licht im UV- oder UV-nahen Bereich ab. Die Umsetzung des UV-Lichts in sichtbares Licht erfolgt durch eine Reaktionsschicht, zum Beispiel durch eine Phosphorschicht. Diese Reaktionsschicht ist in einem Gehäuse der LED untergebracht.

Aufgrund ihrer Flexibilität werden elektronische Schaltungen je nach Anwendungsfall auf einem flexiblen Substrat, beispielsweise auf einer Trägerfolie, angeordnet. Anstelle der Montage auf eine starre Leiterplatte können LEDs grundsätzlich auch auf eine flexible Folie als Trägermaterial aufgebracht werden. Die Fertigung ist jedoch im Allgemeinen aufwändig, da das Gehäuse einer LED nicht mit herkömmlichen Bestückungsanlagen auf ein Foliensubstrat aufgebracht werden kann.

In DE 10 2012 101463 A1 ist ein Verfahren zum Herstellen eines optoelektronischen Bauelements beschrieben, bei dem ein substratloser optoelektronischer Halbleiterchip auf einem elektrisch isolierenden Träger angeordnet ist, der wiederum auf einem elektrisch leitenden Trägersubstrat platziert ist. Ein Abdecksubstrat ist einstückig mit dem Trägersubstrat ausgebildet. Das Abdecksubstrat weist ein strahlungsbeeinflussendes Element auf, das als ein Konversionsplättchen ausgebildet sein kann, um von dem Halbleiterchip emittierte Strahlung in Strahlung einer anderen Wellenlänge umzuwandeln.

In US 2013/033888 A1 ist einer Beleuchtungsvorrichtung gezeigt, bei der eine LED-Lichtquelle auf einer Trägerfolie angeordnet ist. Auf einem weiteren Abschnitt der Trägerfolie ist ein Material zur Wellenlängenkonvertierung aufgetragen. Die Trägerfolie wird derart umgefaltet, dass die lichtkonvertierende Schicht über einer Lichtaustrittsfläche der LED-Lichtquelle liegt. Durch die Verwendung einer LED in Kombination mit dem wellenlängenkonvertierenden Material wird sichtbares Licht erzeugt.

In US2002/0088987-A1 wird eine optische Anordnung offenbart, wobei die optische Anordnung folgende Elemente aufweist: ein Substrat mit einer Öffnung; ein optisches Bauelement, das dieser Öffnung gegenüber liegt und eine lichtdurchlässige Schicht, die sich in der Öffnung des Substrats befindet.

Ein Anliegen der vorliegenden Erfindung ist es, einen Folienaufbau mit Erzeugen von sichtbarem Licht mittels LED-Technologie anzugeben, wobei der Folienaufbau einen kleinen Bauraum aufweist und mit verhältnismäßig geringem Fertigungsaufwand herstellbar ist. Ein weiteres Anliegen der vorliegenden Erfindung ist es, ein Verfahren zum Herstellen eines Folienaufbaus mit Erzeugen von Licht mittels LED-Technologie anzugeben, wobei der Folienaufbau einen geringen Bauraum aufweist und das Herstellverfahren einen verhältnismäßig geringen Aufwand erfordert.

Ein Folienaufbau mit Erzeugen von Licht mittels LED-Technologie ist im Patentanspruch 1 angegeben.

Ein Verfahren zur Herstellung eines Folienaufbaus mit Erzeugen von sichtbarem Licht mittels LED-Technologie ist im Patentanspruch 14 angegeben.

Der Schutzumfang des Patents wird durch die Patentansprüche bestimmt.

Anstelle der Verwendung eines LED-Chips, der zusammen mit einer Reaktionsschicht zur Wandlung des nicht sichtbaren UV-Lichts in sichtbares Licht in einem Kunststoffgehäuse angeordnet ist, wird bei dem vorliegenden Folienaufbau lediglich ein LED-Chip verwendet, der auf einer Trägerfolie angeordnet, in den Folienaufbau integriert ist. Der LED-Chip kann mit Hilfe eines Klebstoffs, beispielsweise eines ACP-Klebstoffs, auf die Trägerfolie geklebt beziehungsweise gebondet werden.

Der LED-Chip strahlt aus der Lichtaustrittsfläche zunächst unsichtbares Licht im UV-Bereich aus. Die zur Erzeugung des sichtbaren Lichts nötige Reaktionsschicht, die das von dem LED-Chip abgestrahlte UV-Licht in sichtbares Licht wandelt, kann entweder auf die gleiche Trägerfolie, auf der auch der LED-Chip angeordnet ist, oder auf eine separate Trägerfolie gedruckt werden. Die Farbreaktionsschicht kann zur Umwandlung des UV-Lichts in sichtbares Licht Phosphor enthalten.

Wenn die Farbreaktionsschicht zusammen mit dem LED-Chip auf der gleichen Trägerfolie angeordnet ist, kann die Trägerfolie derart umgefaltet werden, dass die Farbreaktionsschicht über dem LED-Chip beziehungsweise über einem Lichtaustrittsbereich des LED-Chips oder seitlich versetzt zu dem LED-Chip beziehungsweise seitlich versetzt zu dem Lichtaustrittsbereich des LED-Chips liegt. Bei Verwendung einer separaten Folie, auf der die Farbreaktionsschicht angeordnet ist, kann die separate Trägerfolie über der Trägerfolie mit dem LED-Chip ebenfalls derart platziert werden, dass die Farbreaktionsschicht über dem LED-Chip beziehungsweise über dem Lichtaustrittsbereich des LED-Chips oder seitlich versetzt zu dem LED-Chip beziehungsweise dem Lichtaustrittsbereich des LED-Chips angeordnet ist.

Ein LED-Chip, das heißt ein Chip in Waferform beziehungsweise auf Waferbasis, der aus einem Wafer vereinzelt ist und nicht in einem Gehäuse angeordnet ist, lässt sich mit herkömmlichen Chipbestückungsanlagen verarbeiten und kann, beispielsweise ähnlich wie ein RFID-Chip, maschinell und automatisiert auf der Trägerfolie aufgebracht werden. Ebenso kann die Farbreaktionsschicht zur Umwandlung des UV-Lichts in sichtbares Licht auf einfache Weise drucktechnisch auf der Trägerfolie oder einer separaten Trägerfolie erzeugt werden. Somit kann der Folienaufbau mit dem LED-Chip in rotativer Herstellung von Rolle zu Rolle gefertigt werden.

Die Erfindung wird im Folgenden anhand von Figuren, die Ausführungsformen des Folienaufbaus mit Erzeugen von sichtbarem Licht zeigen, näher erläutert.

Es zeigen:
Figur 1 einen nicht-erfindungsgemäßen Folienaufbau mit Erzeugen von sichtbarem Licht mittels LED-Technologie mit einer umgefalteten Trägerfolie;
Figur 2 einen nicht-erfindungsgemäßen Folienaufbau mit Erzeugen von sichtbarem Licht mittels LED-Technologie mit einer separaten Träger-/Deckfolie zum Aufbringen einer Farbreaktionsschicht;
Figur 3 einen nicht-erfindungsgemäßen Folienaufbau mit Erzeugen von sichtbarem Licht mittels LED-Technologie mit einer umgefalteten Trägerfolie und einem LED-Chip als Kantenstrahler;
Figur 4 einen nicht-erfindungsgemäßen Folienaufbau mit Erzeugen von sichtbarem Licht mittels LED-Technologie mit separater Träger-/Deckfolie und einem LED-Chip als Kantenstrahler;
Figur 5A eine Ausführungsform eines Folienaufbaus mit Erzeugen von sichtbarem Licht mittels LED-Technologie in einer Teilansicht mit einer Farbreaktionsschicht aufgetragen auf einer Trägerfolie in Form eines amplitudenmodulierten Rasters;
Figur 5B eine Ausführungsform eines Folienaufbaus mit Erzeugen von sichtbarem Licht mittels LED-Technologie in einer Teilansicht mit einer Farbreaktionsschicht aufgetragen auf einer Trägerfolie in Form eines frequenzmodulierten Rasters;
Figur 6 eine weitere Ausführungsform eines Folienaufbaus mit Erzeugen von sichtbarem Licht mittels LED-Technologie in einer Teilansicht mit einer UV-Licht sperrenden Schicht;
Figur 7 eine Ausführungsform eines Folienaufbaus mit Erzeugen von sichtbarem Licht mittels LED-Technologie in einer Teilansicht mit einer Farbreaktionsschicht eingemischt in eine Klebstoffschicht;
Figur 8 eine nicht-erfindungsgemäße Ausführungsform eines Folienaufbaus mit Erzeugen von sichtbarem Licht mittels LED-Technologie mit einem berührungsempfindlichen Sensor;
Figur 9 einen nicht-erfindungsgemäßen Folienaufbau mit Erzeugen von sichtbarem Licht mittels LED-Technologie mit einer Abstandsschicht zwischen einer Lichtaustrittsfläche eines LED-Chips und einer Farbreaktionsschicht;
Figur 10A eine Ausführungsform eines Folienaufbaus mit Erzeugen von sichtbarem Licht mittels LED-Technologie mit einer Abstandsschicht in Form eines Schaumes mit Aussparungen in einem Bereich zwischen einer Lichtaustrittsfläche eines LED-Chips und einer Farbreaktionsschicht vor dem Falzen gemäß der Erfindung;
Figur 10B eine weitere Ausführungsform eines Folienaufbaus mit Erzeugen von sichtbarem Licht mittels LED-Technologie mit einer Abstandsschicht in Form eines Schaumes mit Aussparungen in einem Bereich zwischen einer Lichtaustrittsfläche eines LED-Chips und einer Farbreaktionsschicht nach dem Falzen gemäß der Erfindung;
Figur 11 einen nicht-erfindungsgemäßen Folienaufbau mit Erzeugen von sichtbarem Licht mittels LED-Technologie mit einem RFID-Chip mit integrierter LED.

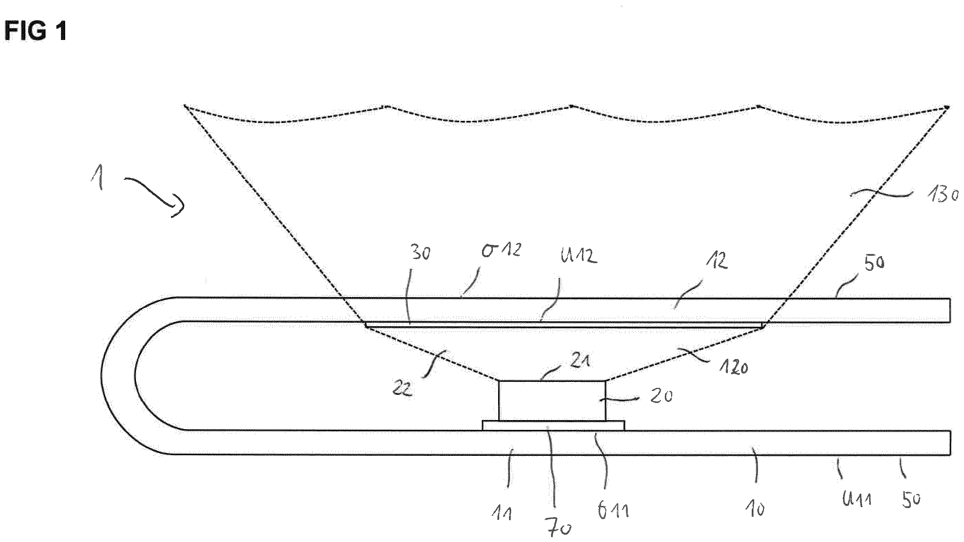

Figur 1 zeigt einen nicht-erfindungsgemäßen Folienaufbau 1 mit einer Trägerfolie 10, auf der ein LED-Chip 20 zum Erzeugen von UV-Licht angeordnet ist. Der LED-Chip 20 weist eine Lichtaustrittsfläche 21 zum Abstrahlen von UV-Licht auf. Der Chip liegt in Waferform vor. Der Chip ist also nicht wie bei einer herkömmlichen LED in einem Kunststoffgehäuse untergebracht. Stattdessen umfasst der LED-Chip 20 nur den Teil des Silizium-Wafers mit der Lichtaustrittsfläche 21, aus der das UV-Licht abgestrahlt wird, sowie eine Kontaktierung, die an der Ober- oder Unterseite des LED-Chips angeordnet sein kann. Zum Umwandeln des von dem LED-Chip 20 ausgestrahlten UV-Lichts in sichtbares Licht weist der Folienaufbau 1 eine Farbreaktionsschicht 30 auf. Die Farbreaktionsschicht ist auf der Trägerfolie 10 angeordnet. Die Trägerfolie 10 ist bei der in Figur 1 dargestellten Ausführungsform derart umgefaltet, dass die Farbreaktionsschicht 30 über dem LED-Chip 20 beziehungsweise über einem Lichtaustrittsbereich 22 der Lichtaustrittsfläche 21 des LED-Chips 20 angeordnet ist.

Der LED-Chip 20 ist auf einem Abschnitt 11 der Trägerfolie 10 angeordnet. Die Farbreaktionsschicht 30 ist auf einem Abschnitt 12 der Trägerfolie 10 angeordnet. Der LED-Chip 20 ist auf einer Oberseite O11 des Abschnitts 11 der Trägerfolie 10 angeordnet. Die Farbreaktionsschicht 30 ist auf einer Unterseite U12 des Abschnitts 12 der Trägerfolie 10, die der Oberseite O11 des Abschnitts 11 der Trägerfolie 10 zugewandt ist, angeordnet. Die in Figur 1 gezeigte Ausführungsform des Folienaufbaus 1 kann auch so modifiziert werden, dass die Farbreaktionsschicht 30 auf einer Oberseite O12 des Abschnitts 12 der Trägerfolie 10, die der Lichtaustrittsfläche 21 des LED-Chips 20 abgewandt ist, angeordnet ist. Die Trägerfolie 10 ist derart umgefaltet, dass der Abschnitt 12 der Trägerfolie 10 über dem Abschnitt 11 der Trägerfolie 10 angeordnet ist.

Bei dem in Figur 1 dargestellten Folienaufbau 1 ist die Lichtaustrittsfläche 21 des LED-Chips 20 parallel zu der Fläche des Abschnitts 12 der Trägerfolie 10 angeordnet, auf der auch die Farbreaktionsschicht 30 angeordnet ist. Das von dem LED-Chip 20 aus der Lichtaustrittsfläche 21 abgestrahlte, für das menschliche Auge nicht-sichtbare UV-Licht 120 trifft auf die Farbreaktionsschicht 30 auf und wird von dieser in sichtbares Licht 130 gewandelt. Das sichtbare Licht 130 durchdringt den Abschnitt 12 der Trägerfolie 10 und wird in die Umgebung abgestrahlt. Zumindest der Abschnitt 12 der Trägerfolie 10 ist lichtdurchlässig ausgebildet.

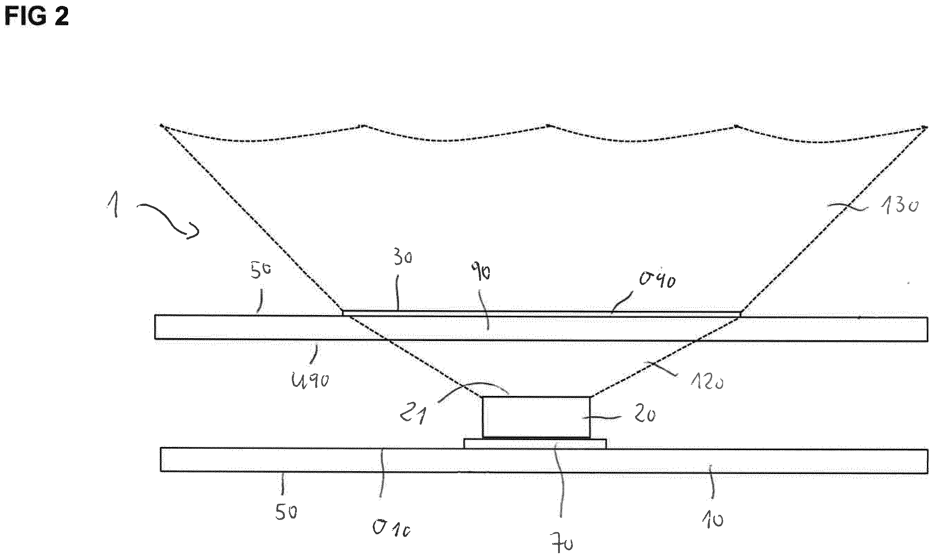

Figur 2 zeigt einen nicht-erfindungsgemäßen Folienaufbau 1 zum Erzeugen von sichtbarem Licht mittels einer LED-Technologie. Der Folienaufbau umfasst die Trägerfolie 10 sowie den LED-Chip 20 zum Erzeugen von UV-Licht mit der Lichtaustrittsfläche 21 zum Abstrahlen des UV-Lichts 120. Der LED-Chip 20 ist auf einer Oberseite O10 der Trägerfolie 10 angeordnet und strahlt aus der Lichtaustrittsfläche 21 UV-Licht 120 nach oben ab. Zum Umwandeln des UV-Lichts 120 in das sichtbare Licht 130 ist die Farbreaktionsschicht 30 vorgesehen.

Im Unterschied zu dem in Figur 1 gezeigten Folienaufbau ist die Farbreaktionsschicht 30 auf einer separaten Träger- beziehungsweise Deckfolie 90 angeordnet. Die Farbreaktionsschicht 30 kann wie bei dem in Figur 1 gezeigten Folienaufbau auf einer Unterseite U90 der separaten Trägerfolie 90 angeordnet sein. In Figur 2 ist ein Folienaufbau gezeigt, bei dem die Farbreaktionsschicht 30 auf einer Oberseite O90 der separaten Trägerfolie 90 angeordnet ist. Die Oberseite O90 der Trägerfolie 90 ist diejenige Oberfläche der Trägerfolie 90, die der Lichtaustrittsfläche 21 des LED-Chips 20 abgewandt ist.

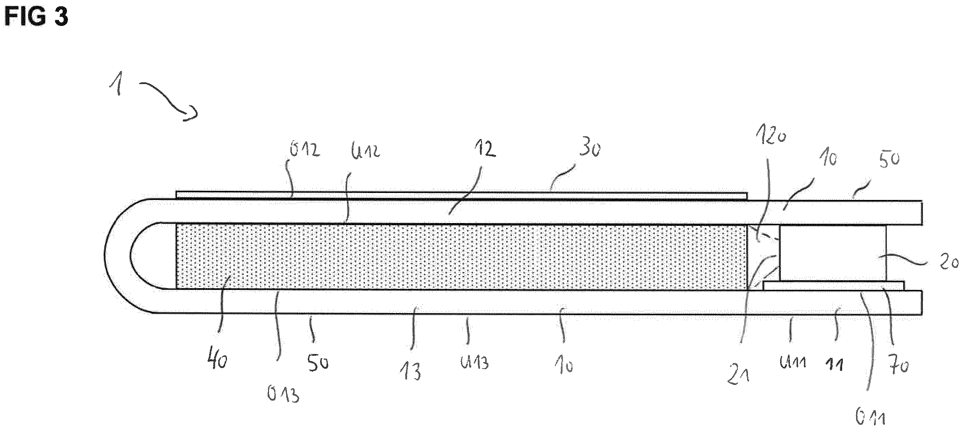

Figur 3 zeigt einen nicht-erfindungsgemäßen Folienaufbau 1 mit einer Trägerfolie 10, auf der ein LED-Chip 20 zum Erzeugen von UV-Licht angeordnet ist. Der LED-Chip 20 ist auf der Oberseite O11 des Abschnitts 11 der Trägerfolie 10 angeordnet. Der LED-Chip 20 weist die Lichtaustrittsfläche 21 zum Abstrahlen des UV-Lichts auf. Weiterhin umfasst der Folienaufbau 1 die Farbreaktionsschicht 30 zum Umwandeln des UV-Lichts in das sichtbare Licht. Bei dem in Figur 3 dargestellten Folienaufbau ist die Farbreaktionsschicht 30 auf dem Abschnitt 12 der Trägerfolie 10, die der Oberseite O11 des Abschnitt 11 der Trägerfolie 10 abgewandt ist, angeordnet. Die Farbreaktionsschicht 30 kann, wie in Figur 3 dargestellt, auf der Oberseite O12 des Abschnitts 12 der Trägerfolie 10 als auch auf der Unterseite U12 des Abschnitts 12 der Trägerfolie 10, die der Oberseite O11 des Abschnitts 11 der Trägerfolie 10 zugewandt ist, angeordnet sein.

Im Unterschied zu dem in Figur 1 gezeigten Folienaufbau ist die Trägerfolie 10 derart umgefaltet, dass die Farbreaktionsschicht 30 seitlich versetzt zu dem LED-Chip 20 beziehungsweise seitlich versetzt zu dem Lichtaustrittsbereich 22 der Lichtaustrittsfläche 21 des LED-Chips 20 angeordnet ist. Die Trägerfolie 10 ist derart umgefaltet, dass der Abschnitt 12 der Trägerfolie 10 seitlich versetzt zu dem Abschnitt 11 der Trägerfolie angeordnet ist. Der LED-Chip 20 ist als ein Kantenstrahler ausgebildet. Die Lichtaustrittsfläche 21 des LED-Chips 20 ist dabei senkrecht zu der Fläche des Abschnitts 12 der Trägerfolie 10 angeordnet, auf der auch die Farbreaktionsschicht 30 vorgesehen ist.

Zwischen dem Abschnitt 11 und dem Abschnitt 12 der Trägerfolie ist ein Abschnitt 13 der Trägerfolie angeordnet. Der Folienaufbau gemäß Figur 3 umfasst eine Abstandsschicht 40. Die Abstandsschicht 40 ist zwischen dem Abschnitt 12 und dem Abschnitt 13 der Trägerfolie 10 angeordnet. Bei dem in Figur 3 gezeigten Folienaufbau 1 ist der LED-Chip 20 als ein Kantenstrahler ausgebildet und strahlt UV-Licht 120 seitlich aus der Lichtaustrittsfläche 21 in die Abstandsschicht 40 ein. Die Abstandsschicht 40 kann als eine Lichtleiterfolie ausgebildet sein, in der das Licht in Richtung der Farbreaktionsschicht 30 abgelenkt beziehungsweise gestreut wird. Das UV-Licht wird in der Farbreaktionsschicht 30 in sichtbares Licht gewandelt und in die Umgebung abgestrahlt.

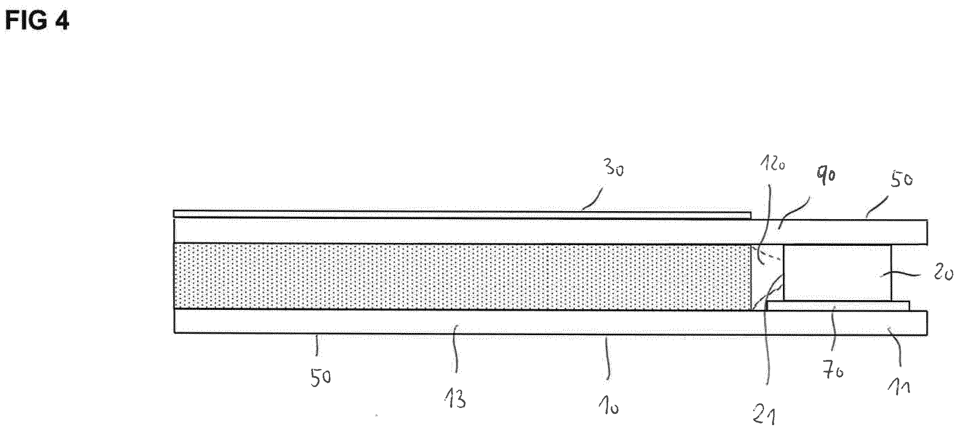

Figur 4 zeigt einen nicht-erfindungsgemäßen Folienaufbau 1 mit einer Trägerfolie 10, auf der ein LED-Chip 20 angeordnet ist. Über dem LED-Chip 20 ist eine separate Träger- beziehungsweise Deckfolie 90 angeordnet. Der Folienaufbau weist die Farbreaktionsschicht 30 zum Umwandeln des aus der Lichtaustrittsfläche 21 des LED-Chips ausgestrahlten UV-Lichts in sichtbares Licht auf. Die Farbreaktionsschicht 30 ist auf der separaten Träger-/Deckfolie 90 angeordnet. Die Farbreaktionsschicht 30 kann auf einer Unterseite U90 oder einer Oberseite O90 der Träger-/Deckfolie 90 angeordnet sein.

Insbesondere ist die Farbreaktionsschicht 30 seitlich versetzt zu dem LED-Chip 20 beziehungsweise seitlich versetzt zu der Lichtaustrittsfläche 21 des LED-Chips 20 angeordnet. Zwischen dem Abschnitt der Träger-/Deckfolie 90, der seitlich versetzt zu dem LED-Chip 20 angeordnet ist und dem Abschnitt der Trägerfolie 10, der seitlich versetzt zu dem LED-Chip 20 angeordnet ist, ist die Abstandsschicht 40 vorgesehen. Der LED-Chip 20 ist wie bei dem in Figur 3 gezeigten Folienaufbau als ein Kantenstrahler ausgebildet. Die Lichtaustrittsfläche 21 des LED-Chips 20 ist parallel zur Normalen auf die Träger-/Deckfolie 90 beziehungsweise parallel zur Normalen auf die Trägerfolie 10 angeordnet. Der LED-Chip 20 strahlt das UV-Licht seitlich aus der Lichtaustrittsfläche 21 in die Abstandsschicht 40 ein. Die Abstandsschicht 40 kann wie bei der in Figur 3 gezeigten Ausführungsform als eine Lichtleiterfolie ausgebildet sein, die das UV-Licht in Richtung der Farbreaktionsschicht 30 ablenkt beziehungsweise streut.

Es sei darauf hingewiesen, dass die Farbreaktionsschicht 30 bei den in den Figuren 3 und 4 gezeigten Folienaufbauten anstelle auf dem Abschnitt 12 der Trägerfolie 10 beziehungsweise auf der Träger-/Deckfolie 90 auch auf einer Ober- oder Unterseite des Bereichs 13 der Trägerfolie 10 angeordnet sein kann. In diesem Fall ist die Abstandsschicht 40 derart ausgebildet, dass sie das eingestrahlte UV-Licht in Richtung des Abschnitts 13 der Trägerfolie 10 ablenkt beziehungsweise streut.

Der LED-Chip 20 kann mit Gleich- und Niederstrom betrieben werden. Dadurch muss keine komplexe Spannungswandlung oder Energiequelle genutzt werden. Zur Zuführung einer Spannung zu dem LED-Chip 20 kann bei den in den Figuren 1 bis 4 gezeigten Folienaufbauten 1 eine elektrische Leiterbahn auf die Trägerfolie 10 aufgebracht sein. Dazu können sämtliche geeignete Druckverfahren, beispielsweise Sieb-, Flexo-, Tief-, Inkjet- oder Tampon-Druck etc. verwendet werden.

Der LED-Chip 20 ist vorzugsweise mit einer Kontaktierung auf der der Lichtaustrittsfläche 21 gegenüber liegenden Seite ausgebildet. Mit Hilfe eines transparenten anisotropen Leitklebers kann auch ein konventioneller LED-Chip mit Kontaktierungen auf der Leuchtseite genutzt werden. Der LED-Chip 20 kann bei dieser Ausführungsform mittels des transparenten, anisotropen leitfähigen Klebstoffs auf die Trägerfolie aufgeklebt sein. Bei den in den Figuren 1 bis 4 dargestellten Folienaufbauten ist ein Klebstoff 70, der insbesondere als ein anisotroper leitfähiger Klebstoff ausgebildet sein kann, auf der Rückseite des LED-Chips 20 aufgetragen, um den LED-Chip 20 auf die Trägerfolie 10 aufzukleben.

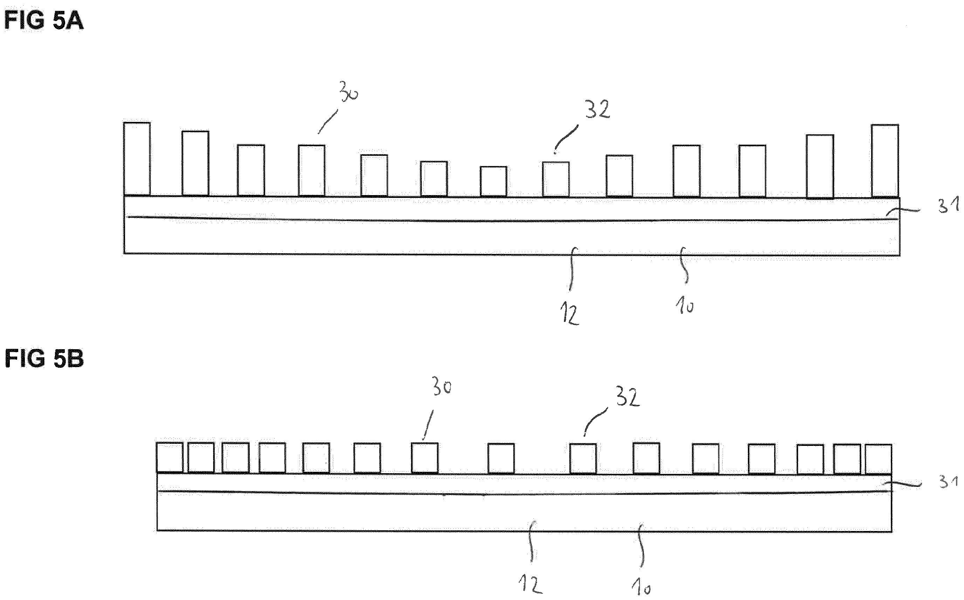

Die folgenden Figuren 5A bis 7 zeigen eine Teilansicht des Folienaufbaus 1. Dargestellt ist lediglich eine Teilansicht des gefalteten Folienaufbaus 1 der Figuren 1 und 3, bei dem die Farbreaktionsschicht 30 auf der Oberseite O12 des Abschnitts 12 der Trägerfolie 10 angeordnet ist. Die in den Figuren 5A bis 7 gezeigten Folienaufbauten sind allerdings auch anwendbar auf die in den Figuren 2 und 4 gezeigten Folienaufbauten mit der separaten Träger-/Deckfolie 90. In diesen Fällen ist die in den Figuren 5A bis 7 gezeigte Farbreaktionsschicht 30 auf der Träger-/Deckfolie 90 angeordnet. Obwohl die Figuren 5A bis 7 die Farbreaktionsschicht 30 auf der Oberseite O12 des Abschnitts 12 der Trägerfolie 10 zeigen, kann die Farbreaktionsschicht bei den beschriebenen Ausführungsformen des Folienaufbaus auch auf der Unterseite U12 des Abschnitts 12 der Trägerfolie 10 oder auf der Unterseite U90 der Träger-/Deckfolie 90 angeordnet sein. Ebenso kann die Farbreaktionsschicht 30 für die im Folgenden beschriebenen Folienaufbauten der Figuren 5A bis 7 auch auf der Ober- beziehungsweise Unterseite des Abschnitts 13 der Trägerfolie 10 angeordnet sein.

Die Farbreaktionsschicht 30 kann auf der Trägerfolie 10, wie in den Figuren 1 bis 4 dargestellt vollflächig aufgebracht sein. Die Figuren 5A und 5B zeigen Folienaufbauten 1, bei dem die Farbreaktionsschicht 30 teilflächig auf der Oberseite O12 des Abschnitts 12 der Trägerfolie 10 angeordnet ist. Dabei kann die Farbreaktionsschicht 30 in Form eines Punkt- oder eines Linienrasters auf die Trägerfolie 10 angeordnet sein. Die Farbreaktionsschicht 30 kann insbesondere als ein amplituden- und/oder frequenzmoduliertes Raster aus Punkten oder Linien auf der Trägerfolie 10 aufgetragen sein. Es können verschiedene additive Auftragsverfahren zum Einsatz kommen.

Bei den in den Figuren 5A und 5B gezeigten Folienaufbauten 1 ist die Farbreaktionsschicht 30 als Schichtenfolge aus zwei verschiedenen Lagen 31 und 32 auf der Trägerfolie 10 aufgetragen. Die unterste Lage 31 der Farbreaktionsschicht 30 ist vollflächig auf der Oberseite O12 des Abschnitts 12 der Trägerfolie 10 angeordnet. Über der Lage 31 ist eine weitere Lage 32 der Farbreaktionsschicht 30 in Form eines Rasters aufgetragen.

Bei dem in Figur 5A gezeigten Folienaufbau ist das Raster amplitudenmoduliert, indem die Höhe der Rasterpunkte/Rasterlinien ausgehend von einer Position im Zentrum über der Lichtaustrittsfläche 21 des LED-Chips zu beiden Rändern der Farbreaktionsschicht 30 zunimmt. Bei dem in Figur 5B gezeigten Folienaufbau ist das Raster frequenzmoduliert, indem die Rasterpunkte/Rasterlinien der Lage 32 der Farbreaktionsschicht 30 im Zentrum oberhalb der Lichtaustrittsfläche 21 des LED-Chips 20 einen großen Abstand aufweisen, der zu beiden Rändern der Farbreaktionsschicht 30 abnimmt.

Ein derartiges amplituden- oder frequenzmoduliertes Raster der Farbreaktionsschicht 30 kann zur Homogenisierung des von dem LED-Chip 20 abgestrahlten Lichts eingesetzt werden. Die vollflächig aufgetragene Lage 31 der Farbreaktionsschicht 30 kann zum Beispiel dazu ausgebildet sein, das von dem LED-Chip 20 ausgestrahlte UV-Licht zu absorbieren, so dass kein UV-Licht in die Umgebung abgestrahlt wird.

Durch die übereinander angeordneten Lagen 31 und 32 können des Weiteren Mischfarben des sichtbaren Lichts erzeugt werden. Die vollflächig aufgetragene Lage 31 der Farbreaktionsschicht 30 kann zum Beispiel einen Phosphor mit einer Emissionswellenlänge von 515 nm aufweist. Die Lage 31 wandelt beispielsweise einfallendes blaues Licht in grünes Licht um. Die Lage 32 der Farbreaktionsschicht 30 kann Phosphor mit einer Emissionswellenlänge von 630 nm aufweisen und wandelt das aus der Lage 31 austretende grüne Licht in rotes Licht um. Ein Betrachter sieht somit das aus den Lagen 31 und 32 der Farbreaktionsschicht 30 austretende Licht als Mischfarbe, beispielsweise als gelbes Licht.

Die Leuchtstoffe kommen in einer Abstufung von 5 nm vor und können demnach fast jede beliebige Farbe erzeugen. Durch den geschickten Druck übereinander können somit mit nur wenigen Grundfarben viele verschiedene Farben erzeugt werden, und die Produktionskomplexität kann reduziert werden.

Eine weitere Möglichkeit zur Homogenisierung des von dem LED-Chip 20 abgestrahlten Lichts ist die Verwendung von "selbstleuchtenden" Phosphorpartikeln in der Farbreaktionsschicht 30, die auf die Trägerfolie 10 aufgetragen, beispielsweise aufgedruckt, werden. Um die resultierende Leuchtfarbe, die nach Anstrahlung von UV-Licht von der Farbreaktionsschicht 30 abgestrahlt wird, zu beeinflussen, können Tagesleuchtpigmente in die Farbreaktionsschicht 30 eingemischt werden. Die Mischung kann durch Druckschichten oder in flüssiger Form erfolgen.

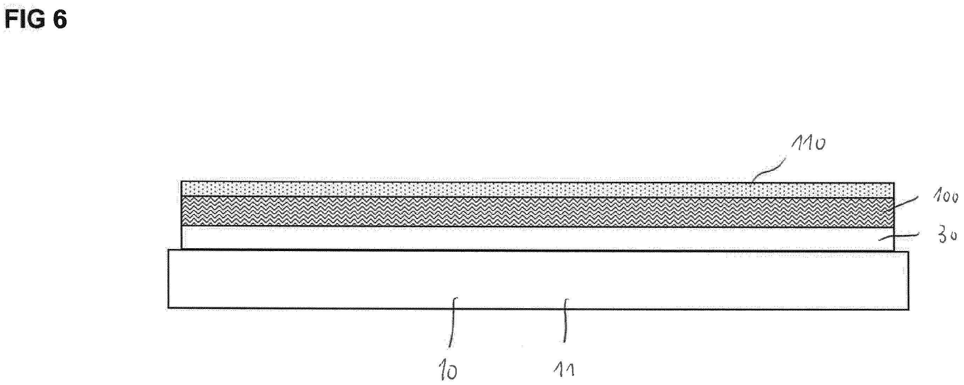

Figur 6 zeigt einen Folienaufbau 1, bei dem zu einem Betrachter hin oberhalb der Farbreaktionsschicht 30 eine UV-Licht sperrende Schicht 100 aufgetragen ist. Oberhalb der UV-Licht sperrenden Schicht 100 kann optional eine Farbschicht 110, beispielsweise eine weiße Farbschicht, aufgetragen sein. Durch die Verwendung einer derartigen Schichtenfolge zwischen der Farbreaktionsschicht 30 und dem Umgebungslicht kann der Effekt zwischen ein- und ausgeschaltetem Zustand des LED-Chips verstärkt werden.

Im ausgeschalteten Zustand des LED-Chips verhindert die UV-Licht sperrende Schicht 100, dass für einen Betrachter beispielsweise ein Symbol, das durch eine entsprechende Strukturierung in die Farbreaktionsschicht 30 eingeprägt ist, sichtbar ist. Stattdessen sieht der Betrachter im ausgeschalteten Zustand des LED-Chips 20 lediglich die weiße Farbschicht 110. Erst im eingeschalteten Zustand des LED-Chips 20 wird das in die Farbreaktionsschicht 30 eingeprägte Muster aufgrund der Hinterleuchtung der Farbreaktionsschicht 30 durch das von dem LED-Chip abgestrahlte Licht für einen Betrachter sichtbar.

Zum Aufkleben der Trägerfolie 10 auf einen Untergrund kann die Trägerfolie 10 selbstklebend oder teilweise klebend ausgebildet sein. Dazu kann eine Klebstoffschicht 50, wie in den Figuren 1 und 3 gezeigt, auf die Oberseite O12 des Abschnitts 12 der Trägerfolie 10 und/oder auf die Unterseite U11 des Abschnitts 11 und/oder auf die Unterseite U13 des Abschnitts 13 der Trägerfolie 10 aufgetragen sein. Bei den Folienaufbauten der Figuren 2 und 4 kann die Klebstoffschicht 50 auf der Oberseite O90 der Träger-/Deckfolie 90 und/oder auf der Unterseite U11 des Abschnitts 11 und/oder auf der Unterseite U13 des Abschnitts 13 der Trägerfolie 10 angeordnet sein.

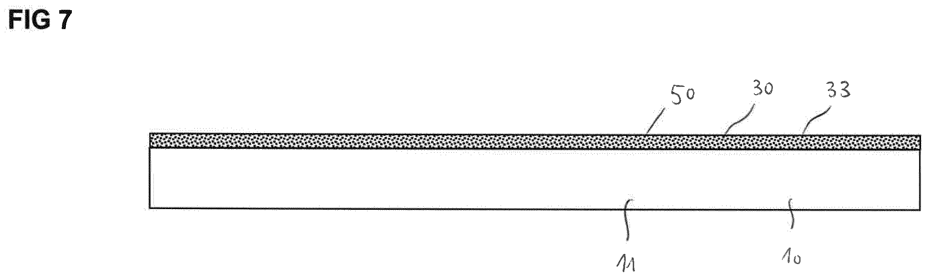

Figur 7 zeigt den Folienaufbau 1 mit der Klebstoffschicht 50, die zum Aufbringen des Folienaufbaus 1 auf ein Substrat auf einer Oberseite O12 des Abschnitts 12 der Trägerfolie 10 angeordnet ist. Der Folienaufbau 1 lässt sich mittels der Klebstoffschicht 50 beispielsweise zur Hinterleuchtung eines Objekts auf die Rückseite des Objekts aufkleben. Figur 7 zeigt den Folienaufbau 1, bei dem die Farbreaktionsschicht 30 in die Klebstoffschicht 50 integriert ist, indem Partikel 33 der Farbreaktionsschicht 30, die das UV-Licht in sichtbares Licht wandeln, in die Klebstoffschicht 50 eingemischt sind. Beim Aufkleben des Folienverbundes auf eine transparente/semitransparente Scheibe kann somit eine leuchtende Fläche erzeugt werden, wenn der LED-Chip 20 eingeschaltet wird.

Die Partikel 33 der Farbreaktionsschicht 30, insbesondere die Phosphorpartikel, können gemäß einer anderen Ausführungsform über ein kontaktloses Verfahren, beispielsweise durch ein Inkjet-Druckverfahren oder durch Dispensen auf die Klebstoffschicht 50 aufgebracht werden. Somit kann unter Umständen eine Folienschicht eingespart werden.

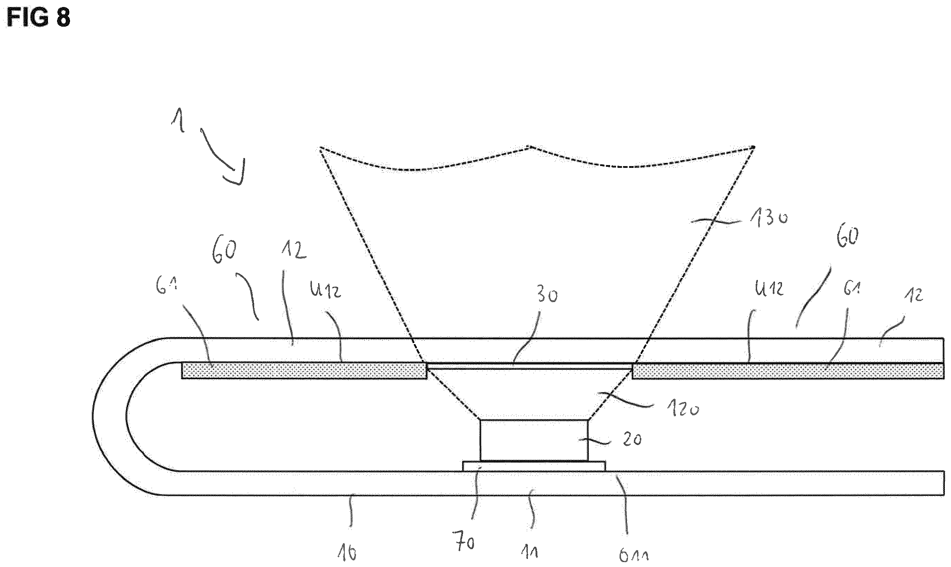

Die Figuren 8 bis 10 zeigen weitere Varianten des Folienaufbaus 1 am Beispiel von Folienaufbauten mit einer umgefalteten Trägerfolie 10, wie sie in den Figuren 1 und 3 dargestellt sind. Die in den Figuren 8 bis 10 dargestellten Varianten des Folienaufbaus sind ebenso anwendbar bei Folienaufbauten mit separater Träger-/Deckfolie 90, wie sie in den Figuren 2 und 4 gezeigt sind.

Figur 8 zeigt einen nicht-erfindungsgemäßen Folienaufbau 1, der einen berührungsempfindlichen Sensor 60 umfasst. Der berührungsempfindliche Sensor 60 umfasst eine leitfähige Struktur 61, beispielsweise eine Leiterbahn, die auf der Unterseite U12 des Abschnitts 12 der Trägerfolie 10 angeordnet ist. Dadurch ist es möglich, einen kapazitiven Schalter auf den Abschnitt 12 der Trägerfolie 10 aufzudrucken. Die gedruckte leitfähige Struktur 61 bildet eine Kondensatorplatte des kapazitiven Sensors. Sie kann an eine in Figur 8 nicht dargestellte Auswerteelektronik beziehungsweise an die Ansteuerelektronik zur Steuerung des LED-Chips angeschlossen sein. Insbesondere bei Folienaufbauten mit umgefalteter Trägerfolie kann die leitfähige Struktur 61 vor dem Falzen in einer Ebene gedruckt werden und ist nach dem Falzen in zwei Ebenen vorhanden. Somit ist es möglich, einen kapazitiven Schalter auf die spätere Deckschicht des LED-Chips zu drucken, wobei der LED-Chip in einem Abstand unter dem kapazitiven Schalter angeordnet ist.

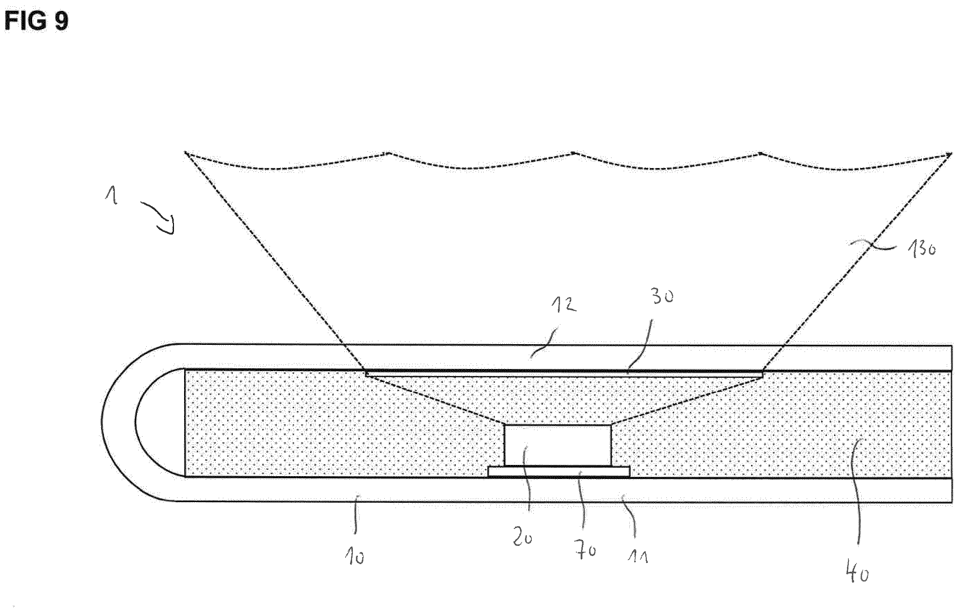

Die Lichtausbeute des aus der leuchtenden Fläche der Farbreaktionsschicht 30 austretenden Lichts kann über die Schichtreihenfolge und die Abstände zwischen der Lichtaustrittsfläche 21 und der Farbreaktionsschicht 30 beeinflusst werden. Figur 9 zeigt einen nicht-erfindungsgemäßen Folienaufbau 1, bei dem zwischen der Lichtaustrittsfläche 21 des LED-Chips 20 und der Farbreaktionsschicht 30 eine Abstandsschicht 40 angeordnet ist, um den Abstand zwischen der Lichtaustrittsfläche 21 und der Farbreaktionsschicht 30 zu beeinflussen. Die Abstandsschicht 40 kann auch, wie in den Figuren 3 und 4 gezeigt, zwischen dem Abschnitt 13 der Trägerfolie 10 und dem Abschnitt 12 der Trägerfolie 10 beziehungsweise zwischen dem Abschnitt 13 der Trägerfolie 10 und der Träger-/Deckfolie 90 angeordnet sein.

Die Abstandsschicht 40 kann als eine transparente Folie in entsprechender Dicke ausgebildet sein. Des Weiteren kann als Abstandsschicht 40 eine transparente Folie mit Prismen zur Lichtverteilung verwendet werden. Weiterhin kann als Abstandsschicht 40 eine mattierte (milchige) Folie verwendet werden. Des Weiteren besteht die Möglichkeit, als Abstandsschicht 40 gedruckte klare und farbige Lacke (ähnlich einer Blindenschrift), teil- und vollflächig zwischen der Lichtaustrittsfläche 21 des LED-Chips 20 und der Farbreaktionsschicht 30 anzuordnen. Weiterhin können zwischen der Lichtaustrittsfläche 21 des LED-Chips 20 und der Farbreaktionsschicht 30 gedruckte Tropfen als Abstandsschicht 40 aufgebracht werden, die einen Linseneffekt haben.

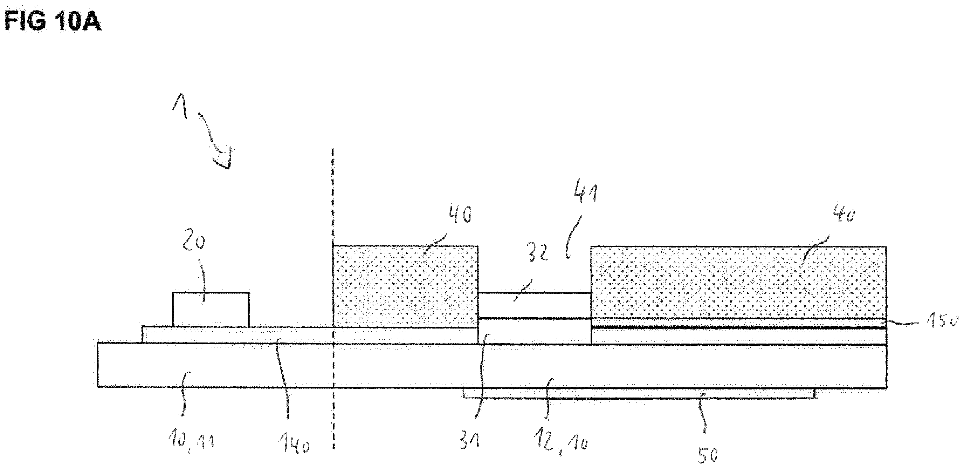

Figur 10A zeigt eine erfindungsgemäße Ausführungsform eines Folienaufbaus 1 vor dem Falzen der Trägerfolie 10. Die Trägerfolie 10 wird an der strichliiert gezeigten Falzlinie umgefaltet. Zur Zuführung einer Spannung zu dem LED-Chip 20 ist eine Leiterbahn 140 auf der Trägerfolie 10 aufgeklebt. Links der Falzlinie ist der LED-Chip 20 mit der eine Spannung zuführenden Leiterbahn 140 angeordnet. Rechts der Falzlinie ist über der Leiterbahn 140 ein zweischichtiger Aufbau der Farbreaktionsschicht 30 aus einer Lage 31 und einer Lage 32 aufgetragen. Ein Abschnitt der Leiterbahn 140 ist mit einer Schutzschicht 150 bedeckt. Die Rückseite der Trägerfolie 10 ist mit einer Schicht aus einem Transferkleber 50 versehen, um den Folienaufbau auf einem Substrat aufzukleben.

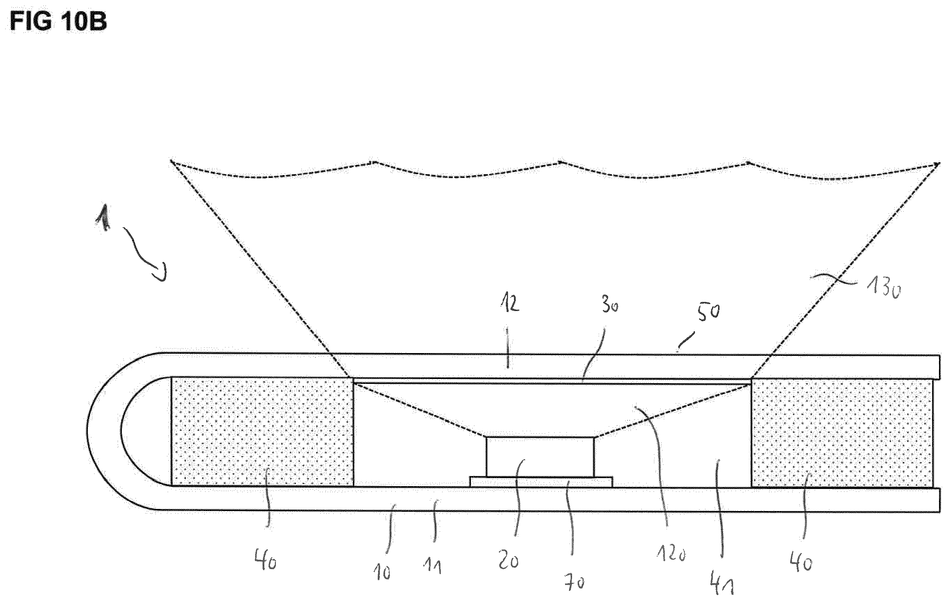

Zur Herstellung eines definierten Abstands zwischen den Lagen 31 und 32 der Farbreaktionsschicht 30 ist die Abstandsschicht 40 in Form eines Schaums vorgesehen. Über der Farbreaktionsschicht 30 weist die Abstandsschicht 40 einen ausgesparten Bereich 41 auf, sodass Licht von der Lichtaustrittsfläche 21 des LED-Chips 20 auf die Farbreaktionsschicht 30 einfallen kann. Figur 10B zeigt den Folienaufbau der Figur 10A nach dem Falzen. Der einfacheren Darstellung wegen ist die Leiterbahn 140 mit der Schutzschicht 150 nicht dargestellt.

Gemäß einer anderen Ausführungsform kann die Abstandsschicht 40 aus dem Schaum auch vollflächig über der Farbreaktionsschicht 30 aufgetragen sein, wenn ein lichttransparenter Schaum beziehungsweise eine Schaumstruktur zur Lichtverteilung benutzt wird.

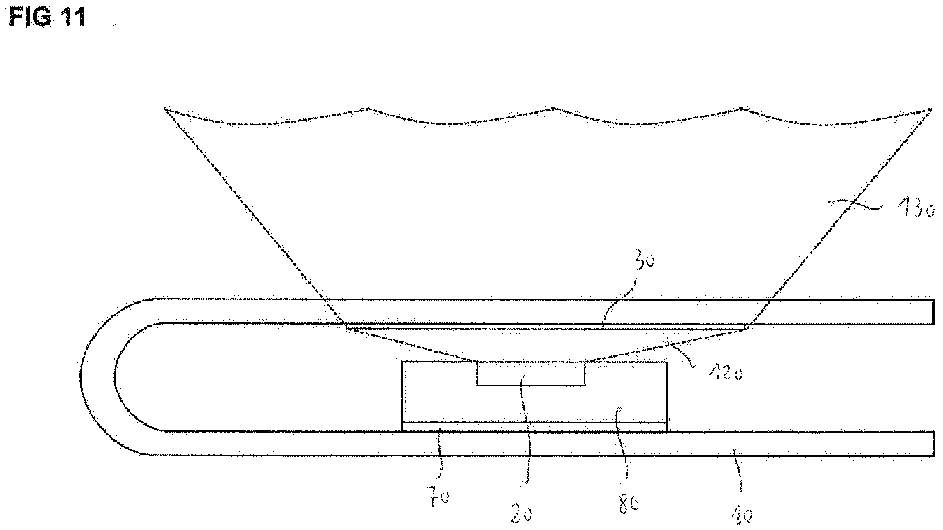

Figur 11 zeigt einen nicht-erfindungsgemäßen Folienaufbau 1 mit einem RFID-Chip 80, der auf der Trägerfolie 10 angeordnet ist. Der LED-Chip 20 kann in dem RFID-Chip 80 integriert sein und dazu ausgebildet sein, einen Betriebszustand des RFID-Chips 80 anzuzeigen. Der LED-Chip 20 kann digital gesteuert sein. Damit ist es beispielsweise möglich, optisch zu erkennen, ob der RFID-Chip 80 gelesen wird. Die Energie des RFID-Feldes ist ausreichend zum Betreiben des LED-Chips 20.

Der Gesamtaufbau des Folienverbundes 1 kann analog zu RFID-Inlays verarbeitet werden. Der Folienverbund 1 kann beispielsweise mit Klebstoffen und weiteren Laminaten veredelt werden. Darüber hinaus kann der Folienaufbau 1 verspritzt, vergossen oder umschäumt werden, um in ein Endprodukt integriert zu werden.

Figur 11 zeigt eine Ausführungsform des Folienaufbaus 1 mit einem RFID-Chip 80, der auf der Trägerfolie 10 angeordnet ist. Der LED-Chip 20 kann in dem RFID-Chip 80 integriert sein und dazu ausgebildet sein, einen Betriebszustand des RFID-Chips 80 anzuzeigen. Der LED-Chip 20 kann digital gesteuert sein. Damit ist es beispielsweise möglich, optisch zu erkennen, ob der RFID-Chip 80 gelesen wird. Die Energie des RFID-Feldes ist ausreichend zum Betreiben des LED-Chips 20.

Der Gesamtaufbau des Folienverbundes 1 kann analog zu RFID-Inlays verarbeitet werden. Der Folienverbund 1 kann beispielsweise mit Klebstoffen und weiteren Laminaten veredelt werden. Darüber hinaus kann der Folienaufbau 1 verspritzt, vergossen oder umschäumt werden, um in ein Endprodukt integriert zu werden.

### Bezugszeichenliste

- 1: Folienaufbau
- 10: Trägerfolie
- 20: LED-Chip
- 30: Farbreaktionsschicht
- 40: Abstandsschicht
- 50: Klebstoffschicht
- 60: berührungsempfindlicher Sensor
- 70: Klebstoff
- 80: RFID-Chip
- 90: Träger-/Deckfolie
- 100: UV-Licht sperrende Schicht
- 110: Farbschicht
- 120: UV-Licht
- 130: sichtbares Licht
- 140: Leiterbahn
- 150: Schutzschicht

## Patentansprüche

1. Folienaufbau mit Erzeugen von sichtbarem Licht mittels LED-Technologie, umfassend:
- eine Trägerfolie (10),
- einen LED-Chip (20) zum Erzeugen von UV-Licht (120), wobei der LED-Chip (20) auf einem ersten Abschnitt (11) der Trägerfolie (10) angeordnet ist und eine Lichtaustrittsfläche (21) zum Abstrahlen des UV-Lichts (120) aufweist,
- eine Farbreaktionsschicht (30) zum Umwandeln des UV-Lichts (120) in das sichtbare Licht (130), wobei die Farbreaktionsschicht (30) drucktechnisch auf einem zweiten Abschnitt (12) der Trägerfolie (10) angeordnet ist,
- eine Abstandsschicht (40), die zwischen dem ersten und zweiten Abschnitt (11, 12) der Trägerfolie (10) angeordnet ist,
- wobei die Trägerfolie (10) derart umgefaltet ist, dass der zweite Abschnitt (12) der Trägerfolie (10) über dem ersten Abschnitt (11) der Trägerfolie angeordnet ist und die Farbreaktionsschicht (30) über dem LED-Chip (20) oder seitlich versetzt zu dem LED-Chip (20) angeordnet ist,
**dadurch gekennzeichnet, dass** die Abstandsschicht (40) einen ausgesparten Bereich (41) aufweist, so dass Licht bei einem Lichtaustritt von der Lichtaustrittsfläche (21) des LED-Chips (20) auf die Farbreaktionsschicht (30) einfällt.

2. Folienaufbau nach Anspruch 1,
wobei die Lichtaustrittsfläche (21) des LED-Chips (20) parallel zu der Fläche des zweiten Abschnitts (12) der Trägerfolie (10), auf der die Farbreaktionsschicht (30) angeordnet ist, angeordnet ist.

3. Folienaufbau nach Anspruch 2,
- wobei der LED-Chip (20) auf einer Oberseite (O11) des ersten Abschnitts (11) der Trägerfolie (10) angeordnet ist,
- wobei die Farbreaktionsschicht (30) auf einer Unterseite (U12) des zweiten Abschnitts (12) der Trägerfolie (10), die der Oberseite (O11) des ersten Abschnitts (11) der Trägerfolie (10) zugewandt ist, angeordnet ist.

4. Folienaufbau nach Anspruch 2 oder 3,
- wobei der LED-Chip (20) auf einer Oberseite (O11) des ersten Abschnitts (11) der Trägerfolie (10) angeordnet ist,
- wobei die Farbreaktionsschicht (30) auf einer Oberseite (O12) des zweiten Abschnitts (12) der Trägerfolie (10), die der Oberseite (O11) des ersten Abschnitts (11) der Trägerfolie (10) abgewandt ist, angeordnet ist.

5. Folienaufbau nach einem der Ansprüche 2 bis 4, umfassend:
eine Klebeschicht (50) zum Aufbringen des Folienaufbaus (1) auf ein Substrat, wobei die Klebeschicht (50) auf einer Oberseite (O12) des zweiten Abschnitts (12) der Trägerfolie (10), die der Unterseite (U11) des ersten Abschnitts (11) der Trägerfolie abgewandt ist, angeordnet ist.

6. Folienaufbau nach Anspruch 5,
- wobei die Farbreaktionsschicht (30) Partikel (33) aufweist, die das UV-Licht (120) in das sichtbare Licht (130) wandeln,
- wobei die Partikel (33) in die Klebeschicht (50) eingemischt sind.

7. Folienaufbau nach einem der Ansprüche 2 bis 5, umfassend:
- einen berührungsempfindlichen Sensor (60),
- wobei der LED-Chip (20) auf einer Oberseite (O11) des ersten Abschnitts (11) der Trägerfolie (10) angeordnet ist,
- wobei der berührungsempfindliche Sensor (60) eine leitfähige Struktur (61) umfasst, die auf der Unterseite (U12) des zweiten Abschnitts (12) der Trägerfolie (10), die der Oberseite (O11) des ersten Abschnitts (11) der Trägerfolie zugewandt ist, angeordnet ist.

8. Folienaufbau nach einem der Ansprüche 1 bis 7,
wobei der LED-Chip (20) mittels eines transparenten, anisotropen leitfähigen Klebstoffs (70) auf die Trägerfolie (10) aufgeklebt ist.

9. Folienaufbau nach einem der Ansprüche 1 bis 8,
wobei die Abstandsschicht (40) als eine transparente Folie oder als eine transparente Folie mit Prismen zur Lichtverteilung oder als eine mattierte Folie oder als ein klarer, farbloser Lack oder als ein farbiger Lack oder als ein Schaum ausgebildet ist.

10. Folienaufbau nach einem der Ansprüche 1 bis 9, umfassend:
- einen RFID-Chip (80), der auf der Trägerfolie (10) angeordnet ist,
- wobei der LED-Chip (20) in den RFID-Chip (80) integriert ist und einen Betriebszustand des RFID-Chips (80) anzeigt.

11. Verfahren zur Herstellung eines Folienaufbaus mit Erzeugen von sichtbarem Licht, umfassend:
- Bereitstellen einer Trägerfolie (10) und eines LED-Chips (20) zum Erzeugen von UV-Licht (120) mit eine Lichtaustrittsfläche (21) zum Abstrahlen des UV-Lichts (120),
- Anordnen des LED-Chips (20) auf einem ersten Abschnitt (11) der Trägerfolie (10),
- Anordnen einer Abstandsschicht (40) auf einem zweiten Abschnitt (12) der Trägerfolie (10), wobei die Abstandsschicht (40) eine Aussparung (41) aufweist,
- Anordnen einer Farbreaktionsschicht (30) zum Umwandeln des UV-Lichts (120) in das sichtbare Licht (130) auf einem zweiten Abschnitt (12) der Trägerfolie, wobei die Farbreaktionsschicht (30) drucktechnisch auf dem zweiten Abschnitt (12) der Trägerfolie erzeugt wird,
- Umfalten der Trägerfolie (10) derart, dass der zweite Abschnitt (12) der Trägerfolie (10) derart über dem ersten Abschnitt (11) der Trägerfolie angeordnet ist, dass die Farbreaktionsschicht (30) über dem LED-Chip (20) oder seitlich versetzt zu dem LED-Chip (20) angeordnet ist und Licht bei einem Lichtaustritt von der Lichtaustrittsfläche (21) des LED-Chips (20) durch den ausgesparten Bereich (41) der Abstandsschicht (40) auf die Farbreaktionsschicht (30) einfällt.

## Claims

1. A film structure with generation of visible light by means of LED technology, comprising:
- a carrier film (10),
- an LED chip (20) for generating UV light (120), the LED chip (20) being arranged on a first portion (11) of the carrier film (10) and having a light outlet surface (21) for irradiating the UV light (120),
- a color reaction layer (30) for converting the UV light (120) into the visible light (130), the color reaction layer (30) being arranged on a second portion (12) of the carrier film (10) by means of printing technology,
- a spacer layer (40) arranged between the first and second portions (11, 12) of the carrier film (10),
- the carrier film (10) being folded over in such a way that the second portion (12) of the carrier film (10) is arranged above the first portion (11) of the carrier film and the color reaction layer (30) is arranged above the LED chip (20) or so as to be laterally offset with respect to the LED chip (20),
**characterized in that** the spacer layer (40) has a recessed area (41) so that light is incident on the color reaction layer (30) in case of light emission from the light outlet surface (21) of the LED chip (20).

2. The film structure according to claim 1,
wherein the light outlet surface (21) of the LED chip (20) is arranged parallel to the surface of the second portion (12) of the carrier film (10) on which the color reaction layer (30) is arranged.

3. The film structure according to claim 2,
- wherein the LED chip (20) is arranged on an upper side (O11) of the first portion (11) of the carrier film (10),
- wherein the color reaction layer (30) is arranged on a lower side (U12) of the second portion (12) of the carrier film (10), said lower side facing the upper side (011) of the first portion (11) of the carrier film (10).

4. The film structure according to claim 2 or 3,
- wherein the LED chip (20) is arranged on an upper side (O11) of the first portion (11) of the carrier film (10),
- wherein the color reaction layer (30) is arranged on an upper side (012) of the second portion (12) of the carrier film (10), said upper side facing away from the upper side (011) of the first portion (11) of the carrier film (10).

5. The film structure according to any one of claims 2 to 4, comprising:
an adhesive layer (50) for applying the film structure (1) to a substrate, wherein the adhesive layer (50) is arranged on an upper side (012) of the second portion (12) of the carrier film (10), said upper side facing away from the lower side (U11) of the first portion (11) of the carrier film.

6. The film structure according to claim 5,
- wherein the color reaction layer (30) comprises particles (33) that convert the UV light (120) into the visible light (130),
- wherein the particles (33) are mixed into the adhesive layer (50).

7. The film structure according to any one of claims 2 to 5, comprising:
- a touch-sensitive sensor (60),
- wherein the LED chip (20) is arranged on an upper side (O11) of the first portion (11) of the carrier film (10),
- wherein the touch-sensitive sensor (60) comprises a conductive structure (61) which is arranged on the lower side (U12) of the second portion (12) of the carrier film (10), said lower side facing the upper side (011) of the first portion (11) of the carrier film.

8. The film structure according to any one of claims 1 to 7,
wherein the LED chip (20) is adhered to the carrier film (10) by means of a transparent anisotropic conductive adhesive (70).

9. The film structure according to any one of claims 1 to 8,
wherein the spacer layer (40) is formed as a transparent film or as a transparent film with prisms for light distribution or as a frosted film or as a clear colorless varnish or as a colored varnish or as a foam.

10. The film structure according to any one of claims 1 to 9, comprising:
- an RFID chip (80) arranged on the carrier film (10),
- wherein the LED chip (20) is integrated into the RFID chip (80) and indicates an operational state of the RFID chip (80).

11. A method of manufacturing a film structure with generation of visible light, comprising:
- providing a carrier film (10) and an LED chip (20) for generating UV light (120) having a light outlet surface (21) for irradiating the UV light (120),
- arranging the LED chip (20) on a first portion (11) of the carrier film (10),
- arranging a spacer layer (40) on a second portion (12) of the carrier film (10), the spacer layer (40) having a recess (41),
- arranging a color reaction layer (30) for converting the UV light (120) into the visible light (130) on a second portion (12) of the carrier film, the color reaction layer (30) being generated on the second portion (12) of the carrier film by means of printing technology,
- folding the carrier film (10) in such a way that the second portion (12) of the carrier film (10) is arranged above the first portion (11) of the carrier film such that the color reaction layer (30) is arranged above the LED chip (20) or so as to be laterally offset with respect to the LED chip (20) and light is incident on the color reaction layer (30) through the recessed area (41) of the spacer layer (40) in case of light emission from the light outlet surface (21) of the LED chip (20).

## Revendications

1. Structure stratifiée permettant de produire de la lumière visible au moyen de la technologie LED, comprenant :
- un film support (10),
- une puce LED (20) permettant de produire de la lumière UV (120), sachant que la puce LED (20) est disposée sur une première section (11) du film support (10) et présente une surface de sortie de lumière (21) permettant de diffuser la lumière UV (120),
- une couche de réaction colorée (30) permettant de convertir la lumière UV (120) en la lumière visible (130), sachant que la couche de réaction colorée (30) est disposée en termes d'impression sur une deuxième section (12) du film support (10),
- une couche d'entretoise (40) qui est disposée entre la première et la deuxième section (11, 12) du film support (10),
- sachant que le film support (10) est replié de telle manière que la deuxième section (12) du film support (10) soit disposée au-dessus de la première section (11) du film support et la couche de réaction colorée (30) soit disposée au-dessus de la puce LED (20) ou décalée latéralement par rapport à la puce LED (20),
**caractérisée en ce que** la couche d'entretoise (40) présente une zone évidée (41) de telle sorte que de la lumière tombe sur la couche de réaction colorée (30) en cas de sortie de lumière de la surface de sortie de lumière (21) de la puce LED (20).

2. Structure stratifiée selon la revendication 1,
sachant que la surface de sortie de lumière (21) de la puce LED (20) est disposée parallèlement à la surface de la deuxième section (12) du film support (10) sur laquelle la couche de réaction colorée (30) est disposée.

3. Structure stratifiée selon la revendication 2,
- sachant que la puce LED (20) est disposée sur un côté supérieur (O 11) de la première section (11) du film support (10),
- sachant que la couche de réaction colorée (30) est disposée sur un côté inférieur (U12) de la deuxième section (12) du film support (10) qui est tourné vers le côté supérieur (O11) de la première section (11) du film support (10).

4. Structure stratifiée selon la revendication 2 ou 3,
- sachant que la puce LED (20) est disposée sur un côté supérieur (O11) de la première section (11) du film support (10),
- sachant que la couche de réaction colorée (30) est disposée sur un côté supérieur (012) de la deuxième section (12) du film support (10) qui est tourné du côté opposé au côté supérieur (O11) de la première section (11) du film support (10).

5. Structure stratifiée selon l'une des revendications 2 à 4, comprenant :
une couche adhésive (50) permettant d'apposer la structure stratifiée (1) sur un substrat, sachant que la couche adhésive (50) est disposée sur un côté supérieur (012) de la deuxième section (12) du film support (10) qui est tourné du côté opposé au côté inférieur (U11) de la première section (11) du film support.

6. Structure stratifiée selon la revendication 5,
- sachant que la couche de réaction colorée (30) présente des particules (33) qui convertissent la lumière UV (120) en la lumière visible (130),
- sachant que les particules (33) sont mélangées dans la couche adhésive (50).

7. Structure stratifiée selon l'une des revendications 2 à 5, comprenant :
- un capteur sensible au toucher (60),
- sachant que la puce LED (20) est disposée sur un côté supérieur (O11) de la première section (11) du film support (10),
- sachant que le capteur sensible au toucher (60) comprend une structure conductible (61) qui est disposée sur le côté inférieur (U12) de la deuxième section (12) du film support (10) qui est tournée vers le côté supérieur (O11) de la première section (11) du film support.

8. Structure stratifiée selon l'une des revendications 1 à 7,
sachant que la puce LED (20) est collée sur le film support (10) au moyen d'un adhésif (70) conductible transparent anisotrope.

9. Structure stratifiée selon l'une des revendications 1 à 8,
sachant que la couche d'entretoise (40) est constituée comme un film transparent ou comme un film transparent comportant des prismes permettant de répartir de la lumière ou comme un film dépoli ou comme un vernis incolore clair ou comme un vernis coloré ou comme une mousse.

10. Structure stratifiée selon l'une des revendications 1 à 9, comprenant :
- une puce RFID (80) qui est disposée sur le film support (10),
- sachant que la puce LED (20) est intégrée dans la puce RFID (80) et indique un état de fonctionnement de la puce RFID (80).

11. Procédé de fabrication d'une structure stratifiée permettant de produire de la lumière visible, comprenant :
- la mise à disposition d'un film support (10) et d'une puce LED (20) permettant de produire de la lumière UV (120) avec une surface de sortie de lumière (21) permettant de diffuser la lumière UV (120),
- la disposition de la puce LED (20) sur une première section (11) du film support (10),
- la disposition d'une couche d'entretoise (40) sur une deuxième section (12) du film support (10), sachant que la couche d'entretoise (40) présente un évidement (41),
- la disposition d'une couche de réaction colorée (30) permettant de convertir la lumière UV (120) en la lumière visible (130) sur une deuxième section (12) du film support, sachant que la couche de réaction colorée (30) est disposée en termes d'impression sur la deuxième section (12) du film support,
- le repliage du film support (10) de telle manière que la deuxième section (12) du film support (10) soit disposée au-dessus de la première section (11) du film support de telle manière que la couche de réaction colorée (30) soit disposée au-dessus de la puce LED (20) ou décalée latéralement par rapport à la puce LED (20) et de la lumière tombe sur la couche de réaction colorée (30) par la zone évidée (41) de la couche d'entretoise (40) en cas de sortie de lumière de la surface de sortie de lumière (21) de la puce LED (20).
